# EUROPEAN PATENT APPLICATION

(11) **EP 4 495 780 A1**
(43) Date of publication of application: **22.01.2025**
(21) Application number: 23787831.9
(22) Date of filing: 14.04.2023
(51) Int. Cl.: G06F 11/07, G11C 29/44

(54) **MEMORY ERROR PREDICTION METHOD AND APPARATUS, AND DEVICE**

(30) Priority: 16.04.2022 CN 202210400323; 30.06.2022 CN 202210764235
(71) Applicant: Huawei Technologies Co., Ltd., Shenzhen, Guangdong 518129 (CN); Duke Kunshan University, Kunshan Suzhou, Jiangsu 215316 (CN)
(72) Inventor: GU, Xinli, Shenzhen, Guangdong 518129 (CN); XU, Shixin, Shenzhen, Guangdong 518129 (CN); WAN, Jun, Shenzhen, Guangdong 518129 (CN); LUO, Jiaqi, Shenzhen, Guangdong 518129 (CN); TANG, Kun, Shenzhen, Guangdong 518129 (CN); DONG, Weiwei, Shenzhen, Guangdong 518129 (CN)
(74) Representative: Körber, Martin Hans
(86) International application number: PCT/CN2023/088381
(87) International publication number: WO 2023/198189

(57) **Abstract**

This application relates to the computer field, and discloses a memory error prediction method and apparatus, and a device. After memory error data is obtained, a prediction area affected by a memory error and a time range in which the memory error occurs in the prediction area are determined based on time and space information that reflects the memory error and a memory physical structure. There is a connection relationship between memory cells arranged in an array in a memory. Therefore, when an error occurs in at least one memory cell, an error may also occur in an area associated with the at least one memory cell. In this way, a location at which the error occurs in the memory and time at which the error occurs in the memory are determined based on the memory error data, and a potential risk area affected by the memory error and a time range in which the error occurs in the potential risk area are deeply analyzed from a perspective of a hardware structure with reference to the connection relationship that is between the memory cells and that is indicated by the memory physical structure. In comparison with predicting a possible error by analyzing only the memory error data, the method in this application can effectively improve a precision rate and a recall rate of memory error prediction.

## Description

This application claims priorities to Chinese Patent Application No. 202210400323.4, filed with the China National Intellectual Property Administration on April 16, 2022 and entitled "MEMORY FAULT PREDICTION METHOD AND APPARATUS", and to Chinese Patent Application No. 202210764235.2, filed on June 30, 2022 and entitled "MEMORY ERROR PREDICTION METHOD AND APPARATUS, AND DEVICE", both of which are incorporated herein by reference in their entireties.

### TECHNICAL FIELD

This application relates to the computer field, and in particular, to a memory error prediction method and apparatus, and a device.

### BACKGROUND

Usually, an error correction code (Error Correction Code, ECC) technology is used to correct a memory error to ensure availability, reliability, and serviceability (Reliability, Availability and Serviceability, RAS) of a host. When the quantity of memory errors exceeds the error correction capability of the ECC, a correctable error (Correctable Error, CE) of a memory becomes an uncorrectable error (Uncorrectable Error, UCE), thereby causing host restart, host breakdown, or the like. Services are interrupted and data is lost. Therefore, a memory fault is still one of main causes of a system fault.

Currently, a fault severity is predicted based on the correctable error of the memory, and risk management is performed on the memory, for example, the memory is replaced to improve system reliability. However, a current memory error prediction method has a low precision rate and/or a recall rate.

### SUMMARY

This application provides a memory error prediction method and apparatus, and a device, to improve a precision rate and a recall rate of memory error prediction.

According to a first aspect, a memory error prediction method is provided. The method includes: obtaining memory error data, where the memory error data includes time information of a memory error and space information of the memory error when the memory error occurs; and determining, based on the memory error data and a memory physical structure, to describe a prediction area that is to be affected by the memory error in the future and a time range in which the error occurs in the prediction area.

There is a connection relationship between memory cells arranged in an array included in a memory. When an error occurs in at least one memory cell, an error may also occur in an area associated with the at least one memory cell. In this way, a location at which the error occurs in the memory and time at which the error occurs in the memory are determined based on the memory error data, and a potential risk area affected by the memory error and a time range in which the error occurs in the potential risk area are deeply analyzed from a perspective of a hardware structure with reference to the connection relationship that is between the memory cells and that is indicated by the memory physical structure. In comparison with predicting a possible error by analyzing only the memory error data, in the memory error prediction method provided in this embodiment of this application, an area affected by a memory error that has occurred is predicted based on the physical structure between the memory cells in the memory, so that a precision rate and a recall rate of memory error prediction can be effectively improved.

The precision rate is an indicator indicating a precision degree of memory error prediction. A higher precision rate indicates a higher precision degree of memory error prediction. The precision rate indicates a ratio of correctly-predicted memory errors to actually-predicted memory error data in the memory error data. The correctly-predicted memory error is a memory error that actually occurs. In other words, the memory error data may include an incorrectly-predicted memory error, and the incorrectly-predicted memory error is a memory error that does not actually occur but is predicted to occur. According to the memory error prediction method provided in this embodiment of this application, the area affected by the memory error that has occurred can be accurately predicted based on the physical structure relationship between the memory cells in the memory, to reduce a quantity of the incorrectly-predicted memory errors that are included in the actually-predicted memory error data, thereby improving the precision rate of the memory error prediction.

The recall rate is an indicator indicating an error range degree of memory error prediction. The recall rate indicates a ratio of correctly-predicted memory errors to memory errors that actually occur in the memory error data. Therefore, a quantity of incorrectly-predicted memory errors that are included in actually-predicted memory error data is reduced, that is, a quantity of the correctly-predicted memory errors is increased, thereby improving the recall rate of the memory error prediction.

The time information includes a temporal distribution feature of the memory error. For example, the time information includes a quantity of memory errors in unit time, that is, the time information indicates density of correctable errors that occur in the unit time. The space information includes a location of a memory cell in which the error occurs in the memory and a spatial distribution feature of the location. For example, the space information includes a location of the memory error in the memory and a quantity of memory errors at the location, that is, the space information indicates density of correctable errors that occur in the memory physical structure. The memory physical structure includes a connection relationship between memory cells to which a main-word line, a sub-word line, a sub-word line driver, a column selection line, a bit line, a sense amplifier, a row address decoder, and a column address decoder are connected.

If the time information indicates that the quantity of correctable errors that occur in the unit time is large, it indicates that the density of correctable errors that occur in the unit time is high, that is, occurrence frequency of the correctable error is high. If the space information indicates that a quantity of correctable errors that occur at a location in the memory is large, it indicates that density of correctable errors that occur at the location is large, that is, occurrence frequency of the correctable error at the location is high.

Therefore, temporal and spatial measurement values of the correctable error are introduced in a memory error prediction process, to reflect a severity of the correctable error, and indirectly reflect a memory physical fault severity and service access load, so that the precision rate and the recall rate of the memory error prediction are further improved.

In a possible implementation, the determining, based on the memory error data and a memory physical structure, to describe a prediction area that is to be affected by the memory error in the future and a time range in which the error occurs in the prediction area includes: determining a memory error area based on a location, of the memory error, indicated by the space information and a quantity of memory errors at the location, where the memory error area includes one or more hierarchical areas. For example, the memory error area includes at least one of the following: a dual inline memory module, a rank, a memory chip, a bank group, a bank, a subarray, a matrix, a row, a column, and a memory cell. Further, the prediction area affected by the error in the memory error area is determined based on the memory error area and the memory physical structure, and the time range in which the memory error occurs in the prediction area is determined based on the memory error area and the time information.

In an example, the determining a memory error area based on the space information includes: classifying the memory cell in which the error occurs based on a column address range of the memory cell in the memory and a row address range of the memory cell in the memory, to obtain the memory error area. For example, the space information is clustered according to a clustering algorithm to obtain a clustering result, and at least one area included in the clustering result is analyzed based on the location of the memory error in the memory and the quantity of memory errors in the memory, to obtain the memory error area.

In another example, the determining the prediction area based on the memory error area and the memory physical structure includes: determining an association feature between the memory error area and the memory physical structure, and determining the prediction area based on the association feature.

Therefore, areas at proximate locations are classified according to the clustering algorithm, and the memory error area is analyzed, so that the prediction area is inferred based on the memory error area with reference to the memory physical structure, thereby helping improve identification accuracy of the potential risk area.

The prediction area includes at least one of the following: when the memory error area is a single bit, the prediction area is a memory cell; when the memory error area is a single row, the prediction area is a main-word line control area; when the memory error area is a plurality of rows in a single matrix, the prediction area is a sub-word line driver control area; when the memory error area is a single column in a single matrix, the prediction area is a bit line control area; when the memory error area is a single column in a plurality of matrices, the prediction area is a sense amplifier control area; when the memory error area is a plurality of rows in a plurality of matrices, the prediction area is a row address decoder control area; or when the memory error area is a plurality of columns in a plurality of matrices, the prediction area is a column address decoder control area.

In another possible implementation, the method further includes: obtaining an occurrence probability of a correctable error in a same memory area in at least two memory chips, where the memory area includes one of the memory error area and the prediction area; and determining a probability of an uncorrectable error based on the probability of the correctable error in the same memory area in the at least two memory chips.

Because a correctable error occurs in a same memory area in the plurality of memory chips, the uncorrectable error is more likely to be caused. Alternatively, a larger quantity of memory errors in unit time in each of the plurality of memory chips indicates that the uncorrectable error is more likely to be caused. The uncorrectable error is determined by analyzing the correctable errors of the plurality of memory chips. According to the memory error prediction method provided in this embodiment of this application, the area affected by the memory error that has occurred is predicted based on the physical structure between the memory cells in the memory, so that the precision rate and the recall rate of predicting the correctable error can be effectively improved. Further, the uncorrectable error is predicted based on the correctable error and the predicted correctable error, so that a precision rate and a recall rate of predicting the uncorrectable error are also improved.

In another possible implementation, the method further includes: prompting a user with the memory error area, the prediction area, the time range, and the probability of the uncorrectable error. Therefore, a system administrator can intuitively perceive a severity of the memory error, and the system administrator is assisted in determining whether to perform fault processing on the memory in which the error occurs.

In another possible implementation, the obtaining memory error data includes: obtaining the memory error data from memory logs. Because the memory logs include the space information and the time information that are related to the memory error, accuracy of a data source for predicting the memory error is improved.

According to a second aspect, a memory error prediction apparatus is provided. The apparatus includes modules configured to perform the memory error prediction method in any one of the first aspect or the possible designs of the first aspect.

According to a third aspect, a computing device is provided. The computing device includes at least one processor and a memory, and the memory is configured to store a set of computer instructions. When the processor is used as the computing device in any one of the first aspect or the possible implementations of the first aspect to execute the set of computer instructions, the processor performs the operation steps of the memory error prediction method in any one of the first aspect or the possible implementations of the first aspect.

According to a fourth aspect, a computer-readable storage medium is provided, including computer software instructions. When the computer software instructions are run on a computing device, the computing device is enabled to perform the operation steps of the method in any one of the first aspect or the possible implementations of the first aspect.

According to a fifth aspect, a computer program product is provided. When the computer program product runs on a computer, a computing device is enabled to perform the operation steps of the method in any one of the first aspect or the possible implementations of the first aspect.

In this application, based on the implementations according to the foregoing aspects, the implementations may be further combined to provide more implementations.

### BRIEF DESCRIPTION OF DRAWINGS

FIG. 1A and FIG. 1B are a schematic diagram of a memory physical structure according to an embodiment of this application;
FIG. 2 is a schematic diagram of a data processing system according to an embodiment of this application;
FIG. 3 is a schematic flowchart of a memory error prediction method according to an embodiment of this application;
FIG. 4 is a schematic diagram of analyzing a clustering result according to an embodiment of this application;
FIG. 5A and FIG. 5B are a schematic diagram of a clustering result of memory error data according to an embodiment of this application;
FIG. 6 is a schematic diagram of determining a memory error area through two-dimensional projection according to an embodiment of this application;
FIG. 7A and FIG. 7B are a schematic diagram of inferring a prediction area according to an embodiment of this application;
FIG. 8A and FIG. 8B are a schematic diagram of a derivation process of a prediction area according to an embodiment of this application;
FIG. 9 is a schematic flowchart of another memory error prediction method according to an embodiment of this application;
FIG. 10 is a schematic diagram of a structure of a memory error prediction apparatus according to an embodiment of this application; and
FIG. 11 is a schematic diagram of a structure of a computing device according to an embodiment of this application.

### DESCRIPTION OF EMBODIMENTS

A memory (memory) is also referred to as an internal memory and a main memory (main memory). The memory is an important component of a computer system, that is, a communication bridge between an external memory (or referred to as a secondary memory) and a central processing unit (central processing unit, CPU). The memory is configured to temporarily store operation data in the CPU and data exchanged between the CPU and the external memory such as a hard disk. For example, when a computer starts to run, data that needs to be operated is loaded from the memory to the CPU to perform the operation. After the operation is completed, the CPU stores an operation result to the memory.

Classified by operating principles, the memory includes a cache (cache), a read-only memory (Read Only Memory, ROM), and a random access memory (Random Access Memory, RAM).

The cache is located in the CPU and is a memory with a faster access speed than the random access memory. The cache includes a level-1 cache (L1 cache), a level-2 cache (L2 cache), and a level-3 cache (L3 cache). When the CPU writes data into or reads data from the memory, the data is also written into the cache. When the CPU needs the data again, the CPU can read the data from the cache instead of accessing a slower random access memory. Certainly, if the cache is not hit, that is, the CPU fails to read needed data from the cache, the CPU reads the data from the random access memory.

The read-only memory is used to store basic programs and data of a computer, such as a basic input/output system (Basic Input Output System, BIOS) ROM. The data stored in the read-only memory is permanently stored, and even if the read-only memory is powered off, the data stored in the read-only memory is not lost. The read-only memory allows data to be read, but does not allow data to be written. For example, the read-only memory includes a flash memory (Flash Memory).

The random access memory allows data to be read and data to be written. When the random access memory is powered off, data stored in the random access memory is lost. The random access memory includes a dynamic random access memory (dynamic RAM, DRAM) and a static random access memory (static RAM, SRAM).

A memory cell in the dynamic random access memory includes a capacitor and a related element. A quantity of charges stored in the capacitor indicates a signal 0 and a signal 1. The capacitor is subject to electricity leakage, and insufficient charges may result in an error in data stored in the memory cell. Therefore, the dynamic random access memory needs to be periodically refreshed to maintain a charge state. The dynamic random access memory has a simple structure and high integration, and is usually used as a memory chip in a memory module. The memory module may be a circuit board that integrates a plurality of dynamic random access memories, such as, a dual inline memory module (Dual-Inline-Memory-Modules, DIMM). The memory module is inserted into a memory slot of a computer. A capacity of the memory module can be 4 GB, 8 GB, 16 GB, 32 GB, 64 GB, or 128 GB. With development of technologies, the capacity of the memory module is increasingly large.

The memory cell in the static random access memory includes a latch made of a transistor and a related element, and each memory cell has a function of latching the signal 0 and the signal 1. The static random access memory has a fast speed and does not need a refresh operation, but has poor integration and high power consumption, and is usually used in manufacturing a cache with a small capacity but high efficiency.

Classified by memory technology standards, the memory includes a synchronous dynamic random access memory (Synchronous Dynamic RAM, SDRAM), a double-rate synchronous dynamic random access memory (Double data Rate SDRAM, DDR SDRAM), a DDR2 SDRAM, a DDR3 SDRAM, a DDR4 SDRAM, and a DDR5 SDRAM. With development of technologies, rates of the SDRAMs become increasingly faster.

According to hierarchies from large to small, a memory physical structure is divided into a channel (channel), a dual inline memory module (DIMM), a rank (rank), a memory chip (chip), a bank group (bank group), a bank (bank), a subarray (subarray), a matrix (mat), a row (row), a column (column), and a memory cell (cell).

In the computer system, one memory module may refer to one channel. The CPU is connected to at least one memory module by using a memory controller. For example, the CPU is connected to two memory modules. The memory controller is configured to control the memory and is responsible for data exchange between the memory and the CPU. In addition, one memory module may include one or two ranks.

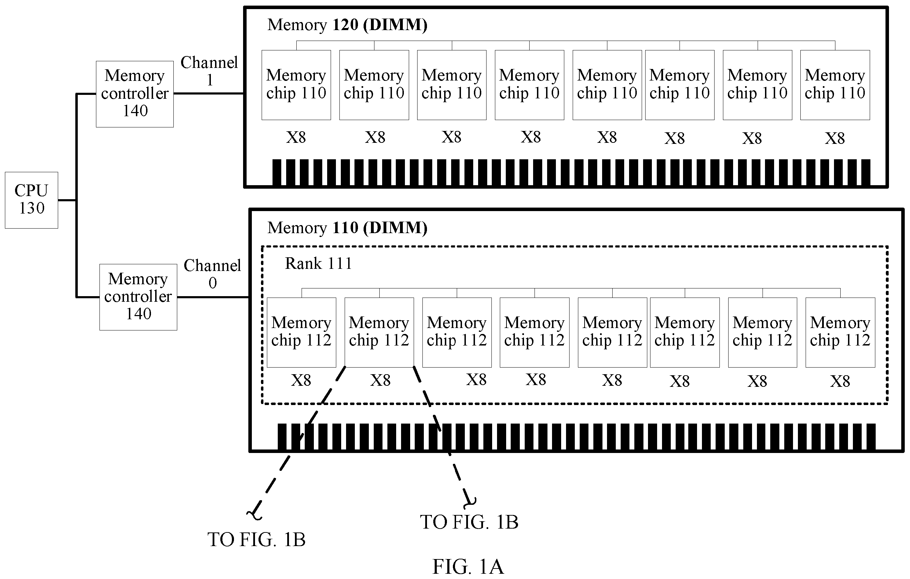

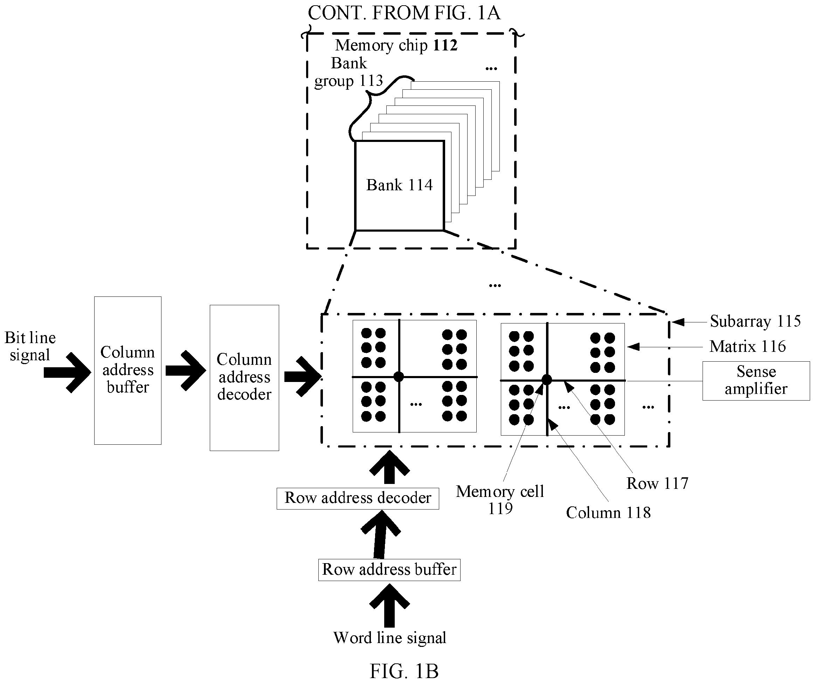

For example, FIG. 1A and FIG. 1B are a schematic diagram of a memory physical structure according to an embodiment of this application. A CPU 130 is connected to a memory 110 and a memory 120 by using a memory controller 140. The memory 110 may refer to a channel 0. The memory 120 may refer to a channel 1. The memory 110 includes a rank 111. The rank 111 includes all memory chips 112 installed on the memory 110. For example, the rank 111 includes eight memory chips 112, and a bit width of each memory chip 112 is 8 bits (bits).

Each memory chip 112 includes a bank group 113. The bank group 113 includes a plurality of banks 114. Each bank 114 includes a plurality of subarrays 115. Each subarray 115 includes a plurality of matrices 116. The matrix 116 includes memory cells 119 arranged in an array. Each memory cell 119 is determined by a row 117 and a column 118.

In the memory cells 119 arranged in an array, memory cells 119 in each row are connected to one row address line, that is, a word line (word line, WL). Memory cells 119 in each column are connected to one column address line, that is, a bit line (bit line, BL). Each word line corresponds to one row address, and each bit line corresponds to one column address. Each memory cell 119 has a unique row address (or a row number) and a unique column address (or a column number), and the row address and the column address together indicate a physical address of the memory cell 119. Each row address line is connected to a plurality of column address lines. Each column address line is connected to a plurality of row address lines.

Each memory cell 119 is connected to a sub-word line driver (SWL driver) by using a sub-word line (second word line, SWL), is connected to a row address decoder (row decoder) by using a main-word line (main word line, MWL), is connected to a sense amplifier (sense amplifier, SA) by using a bit line, and is connected to a column address decoder (or a column decoder (column decoder)) by using a column selection line (column selection line, CSL). The row address decoder (or row decoder (row decoder)) is configured to: obtain a word line signal from a row address buffer, determine a row address based on the word line signal, and activate a word line indicated by the row address. The column address decoder is configured to: obtain a bit line signal from a column address buffer, determine a column address based on the bit line signal, and activate a bit line indicated by the column address. Therefore, a read operation and a write operation are performed on the memory cell 119 determined based on the row address and the column address. Because each word line is connected to a plurality of bit lines, to detect a weak electric potential change on a bit line to which the memory cell 119 belongs, the sense amplifier is configured to amplify an electric potential difference, to correctly identify data stored in the memory cell 119.

The foregoing uses the memory 110 as an example to describe the internal physical structure of the memory. For an internal physical structure of the memory 120, refer to the explanation of the memory 110.

Each memory cell may include one capacitor and one transistor (for example, an N-channel metal-oxide semiconductor field-effect transistor (Metal-Oxide-Semiconductor Field-Effect Transistor, MOSFET)). The capacitor can store an amount of 1-bit data. The transistor is a switch that controls charging/discharging of the capacitor. After the capacitor is charged/discharged, a quantity of charges (or an electric potential) included in the capacitor indicates binary data 0 and 1. The capacitor is subject to electricity leakage, the charge is lost after a period of time, and data is lost due to an insufficient electric potential. Therefore, the capacitor needs to be charged to maintain the electric potential, and the charging action may be referred to as refreshing. For example, refreshing is performed before data changing or powering-off.

Memory performance determines overall operating performance of the computer. Memory performance indicators include a memory frequency, an access speed, a capacity, a latency, and a bandwidth. The memory frequency indicates an operating frequency that the memory can reach. A higher memory frequency indicates a higher operating frequency of the memory. The access speed indicates duration of accessing data once. A faster access speed indicates shorter access time. A larger memory capacity indicates harder frame freezing. The latency indicates a response speed of the memory after receiving an instruction from the CPU, that is, a column address strobe latency (Column Address Strobe Latency, CL).

With evolution of an architecture of the memory, to set more memory cells on a silicon chip with a limited size and perform a read/write operation on the memory more quickly, a process line width dimension of the memory becomes increasingly smaller, and an operating frequency becomes increasingly higher. As a result, the memory is prone to heating up. Therefore, to control the heating up of the memory, an operating voltage is forced to constantly decrease, and consequently reliability of the memory is also constantly reduced.

An embodiment of this application provides a memory error prediction method, and in particular, provides a method for predicting a memory error based on a memory physical structure, that is, determining, based on time information of the memory error and space information of the memory error when the memory error occurs that are included in memory error data and the memory physical structure, to describe a prediction area that is to be affected by the memory error in the future and a time range in which the error occurs in the prediction area. There is a connection relationship between memory cells arranged in an array included in a memory. When an error occurs in at least one memory cell, an error may also occur in an area associated with the at least one memory cell. In this way, a location at which the error occurs in the memory and time at which the error occurs in the memory are determined based on the memory error data, and a potential risk area affected by the memory error and a time range in which the error occurs in the potential risk area are deeply analyzed from a perspective of a hardware structure with reference to the connection relationship that is between the memory cells and that is indicated by the memory physical structure. In comparison with predicting a possible error by analyzing only the memory error data, in the memory error prediction method provided in this embodiment of this application, an area affected by a memory error that has occurred is predicted based on the physical structure between the memory cells in the memory, so that a precision rate and a recall rate of memory error prediction can be effectively improved.

The memory error prediction method provided in this embodiment of this application is applicable to memory error prediction in a plurality of scenarios. For example, a baseboard management controller (Baseboard Management Controller, BMC) in a server obtains memory error data, and performs memory error prediction on a plurality of memories included in the server. For another example, a control node in a cluster obtains memory error data, and performs memory error prediction on a plurality of memories included in the cluster. The plurality of memories in the cluster include at least one of a memory in a computing cluster and a memory in a storage cluster.

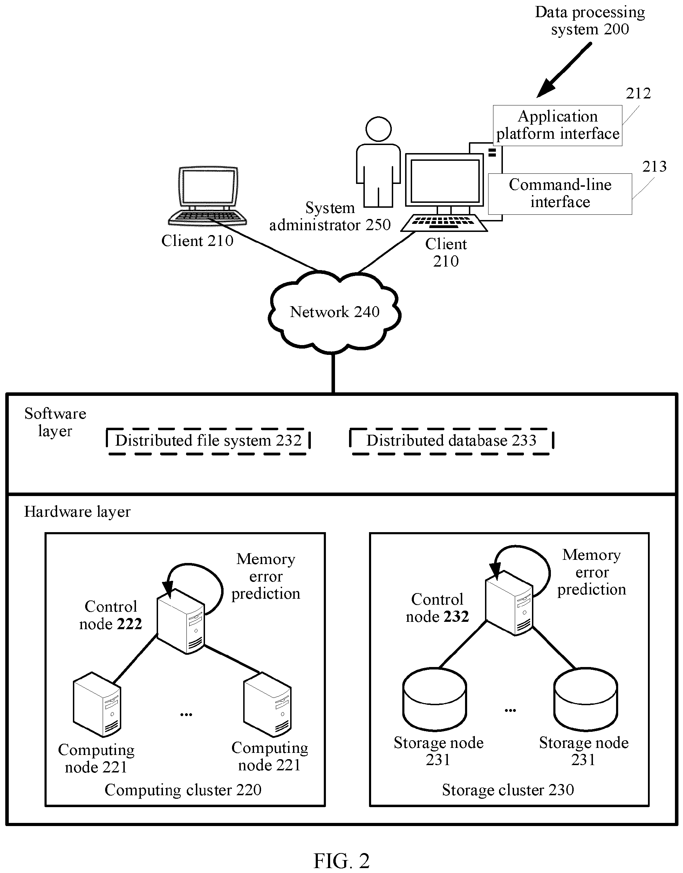

For example, FIG. 2 is a schematic diagram of an architecture of a data processing system according to an embodiment of this application. As shown in FIG. 2, the data processing system 200 includes a client 210, a computing cluster 220, and a storage cluster 230.

The storage cluster 230 includes at least two storage nodes 231. One storage node 231 includes one or more controllers, a memory, a network interface card, and a plurality of hard disks. The hard disk is used to store data. The hard disk may be a magnetic disk or another type of storage medium, for example, a solid-state drive or a shingled magnetic recording hard disk. The network interface card is configured to communicate with a computing node 221 included in the computing cluster 220. The controller is configured to: write data into a hard disk or read data from a hard disk and write data into a memory or read data from a memory according to a data read/write request sent by the computing node 221. In a process of reading/writing data, the controller needs to convert an address carried in the data read/write request into an address that can be identified by the hard disk or the memory.

The client 210 communicates with the computing cluster 220 and the storage cluster 230 over a network 240. For example, the client 210 sends a service request to the computing cluster 220 over the network 240, to request the computing cluster 220 to perform distributed processing on service data included in the service request. The network 240 may be an enterprise internal network (for example, a local area network (Local Area Network, LAN)) or the internet (internet). The data processing system 200 supports running of applications such as big data, a database, high-performance computing, artificial intelligence (Artificial Intelligence, AI), distributed storage, and cloud native applications. In this embodiment of this application, the service data includes data of applications such as big data, a database, high-performance computing, artificial intelligence, distributed storage, and cloud native applications.

The computing cluster 220 includes at least two computing nodes 221, and the computing nodes 221 may communicate with each other. One computing node 221 includes one or more processors, a memory, a network interface card, and a plurality of hard disks. The computing node 221 is a computing device, for example, a server, a desktop computer, or a controller of a storage array. For example, a big data service submitted by the client 210 may be referred to as a job (job). The job can be divided into a plurality of tasks (tasks). A plurality of computing nodes execute the plurality of tasks concurrently. When all the tasks are ended, the job is completed.

The computing cluster 220 further includes a control node 222. The control node 222 is configured to: obtain memory error data of the computing node 221, and determine, based on the memory error data and a memory physical structure, a prediction area affected by a memory error and a time range in which the memory error occurs in the prediction area.

The storage cluster 230 further includes a control node 232. The control node 232 is configured to: obtain memory error data of the storage node 231, and determine, based on the memory error data and a memory physical structure, a prediction area affected by a memory error and a time range in which the memory error occurs in the prediction area.

In some other embodiments, a system administrator 250 may invoke an application platform interface (application platform interface, API) 212, a command-line interface (command-line interface, CLI) interface 213, or a graphical user interface (Graphical User Interface, GUI) by using the client 210 to access a distributed file system 232 and a distributed database 233 to configure system information, for example, the memory error prediction method configured for the computing node 221 and the storage node 231 provided in this embodiment of this application.

The following describes in detail, with reference to the accompanying drawings, implementations of the memory error prediction method provided in this embodiment of this application.

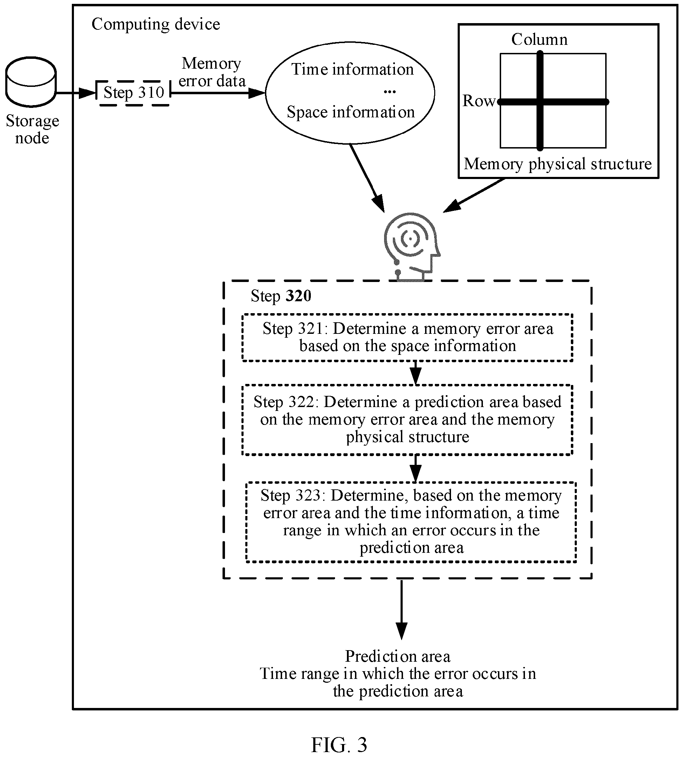

FIG. 3 is a schematic flowchart of a memory error prediction method according to an embodiment of this application. A computing device that performs the method herein may be a BMC in a server, a control node in a cluster, a processor in a single host, or the like. Certainly, the computing device may alternatively be another device that performs memory error prediction. This is not limited. As shown in FIG. 3, the method includes the following steps.

**Step 310: The computing device obtains memory error data.**

The memory error data indicates data that is related to a memory error and that is recorded by a host when the host in which a memory is located does not break down. The memory error refers to an error that can be corrected by using a memory error correction technology (for example, an error correction code (Error Correction Code, ECC)), that is, a correctable error (correctable error, CE). For example, the memory error data includes time information and space information of the memory error.

The time information includes a temporal distribution feature of the memory error. For example, the time information includes a quantity of memory errors that occur in unit time. The time information indicates a quantity or density of correctable errors that occur in the unit time. For example, the time information includes a quantity of correctable errors that occur per hour, and a mean value, a variance, a skewness, a kurtosis, an average absolute deviation, and the like that are obtained based on a quantity of correctable errors that are counted in terms of time.

The space information includes a location of a memory cell in which the error occurs in the memory and a spatial distribution feature of the location. For example, the space information includes a row address and a column address of the memory cell in which the error occurs in the memory, and a quantity of errors that occur at the location. The space information indicates density of correctable errors in a memory physical structure. For example, the space information includes a quantity of ranks, a quantity of memory chips, a quantity of bank groups, a quantity of banks, a quantity of subarrays, a quantity of matrices, a quantity of rows, a quantity of columns, a quantity of memory cells in which correctable errors occur, and a mean value, a variance, a skewness, a kurtosis, an average absolute deviation, and the like that are obtained based on a quantity of correctable errors that are counted in terms of space.

The mean value is obtained by dividing a sum of all data in a group of data by a quantity of pieces of data in the group of data. The mean value is generally an average value. The average value indicates a measure of a central tendency of a group of data, and is an indicator that reflects the central tendency of the data.

The variance is a measure for measuring a dispersion degree of random variables or a group of data in probability theory and statistical variance. In probability theory, the variance is used to measure a deviation degree between a random variable and mathematical expectation (that is, the mean value) of the random variable. In statistics, the variance (a sample variance) is an average value of squared values of differences between all sample values and an average value of all the sample values.

The skewness (skewness) is also referred to as a skewed state and a coefficient of skewness, and is a measure of a skewness direction and degree of statistical data distribution, and is a digital feature of an asymmetry degree of statistical data distribution.

The kurtosis (peakedness or kurtosis) is also referred to as a kurtosis coefficient, and is a feature number representing a peak value, at a location of a mean value, of a probability density distribution curve.

The average absolute deviation is an average value of absolute values of deviations between data and the mean value.

The mean value, the variance, the skewness, and the kurtosis that are obtained based on the quantity of correctable errors reflect a severity and concentration that are of the memory error and service access load. For example, if the mean value, the variance, the skewness, and the kurtosis reflect that time periods or/and locations of the memory in which the correctable error or/and the uncorrectable error occurs/occur are relatively centralized and regular, an occurrence possibility of the correctable error or/and the uncorrectable error in the time periods or/and the locations is higher. For another example, if the mean value, the variance, the skewness, and the kurtosis reflect that time periods or/and locations of the memory in which the correctable error occurs are relatively scattered, the correctable error is likely to occur in a larger area in the memory in more time periods. Memory error prediction is performed by using the data related to the memory error data with reference to the memory physical structure, to improve a precision rate and a recall rate of the memory error prediction.

The computing device may obtain the memory error data from memory logs. For example, as shown in Table 1, the memory logs include a DIMM sequence number, an error time, an error mode, a rank identifier, a bank identifier, a row address, and a column address.

**Table 1**

| Number | DIMM sequence number | Error time | Error mode | Rank identifier | Bank identifier | Row address | Column address |
|---|---|---|---|---|---|---|---|
| 0 | C001 | 2020/5/3 20:12 | CE | 0 | 2 | 54538 | 854 |
| 1 | C001 | 2020/5/3 20:13 | CE | 0 | 2 | 54538 | 896 |
| 2 | C001 | 2020/5/3 20:27 | CE | 0 | 2 | 54313 | 1016 |
| ... | ... | ... | ... | ... | ... | ... | ... |

**Step 320: The computing device determines, based on the memory error data and the memory physical structure, to describe a prediction area that is to be affected by the memory error in the future and a time range in which the error occurs in the prediction area.**

To obtain information included in the memory error data, an algorithm in the machine learning field may be used to mine the memory error data. For example, memory error prediction is performed according to an extreme gradient boost (Extreme Gradient Boost, XGBoost) algorithm, that is, memory error data collected in a plurality of periods of unit time is input into the XGBoost algorithm, and the prediction area affected by the memory error and the time range in which the error occurs in the prediction area are output. The XGBoost algorithm features a multi-decision tree, multi-expert iterative learning, and the like, which improves the precision rate of the memory error prediction. In addition, the XGBoost algorithm features high universality and explainability, which extends application scenarios of the memory error prediction. In addition, the XGBoost algorithm can be parallelized and has a high running speed, which shortens a latency of the memory error prediction.

For another example, the memory error data collected in the plurality of periods of unit time may alternatively be input into a radial basis kernel function (Radical basis kernel function) model, and the prediction area affected by the memory error and the time range in which the memory error occurs in the prediction area are output.

For example, a specific operation process included in step 320 is described in the following step 321 to step 323.

**Step 321: The computing device determines a memory error area based on the space information.**

The computing device classifies the memory cell in which the error occurs based on a column address range of the memory cell in the memory and a row address range of the memory cell in the memory, to obtain the memory error area. For example, a plurality of memory errors included in the space information each indicate one column address and one row address. The memory error may be an error occurring in one bit, and it is determined that the memory error area may be one memory cell. For another example, a plurality of memory errors included in the space information indicate a plurality of column addresses and a plurality of row addresses, and the plurality of column addresses and the plurality of row addresses are classified. The memory error may be an error occurring in a plurality of memory cells in a single row, and it is determined that the memory error area may be a main-word line control area.

Clustering is an unsupervised learning technology for grouping datasets. In a process of clustering, different algorithms can be used to implement clustering. A dataset can be divided into several clusters (clusters) according to a clustering algorithm to ensure that data in a same cluster has a same attribute or feature. In a possible manner, the computing device may cluster, according to the clustering algorithm, memory error locations indicated by the space information, that is, classify memory errors at proximate locations to obtain a clustering result, where the clustering result includes at least one type of area. Each type of area includes a plurality of memory errors at proximate locations. For example, physical addresses of memory errors in a same area are proximate. Area sizes may be different, and area shapes may also be different.

In some embodiments, the computing device optimizes a plurality of clusters according to the statistical distribution 3 Sigma (3σ) law. The 3σ law is also referred to as the PauTa criterion. In the 3σ law, it is first assumed that a group of data includes a random error, computing processing is performed on the group of data to obtain a standard deviation, and an interval is determined based on a preset probability. An error that exceeds the interval is not a random error but a coarse error, and data including the coarse error is removed. In this embodiment of this application, data in one cluster is filtered according to the 3σ law, and a point that is far away from a center point of the cluster is removed, thereby improving accuracy of determining an area, and reducing an error in determining the memory error area.

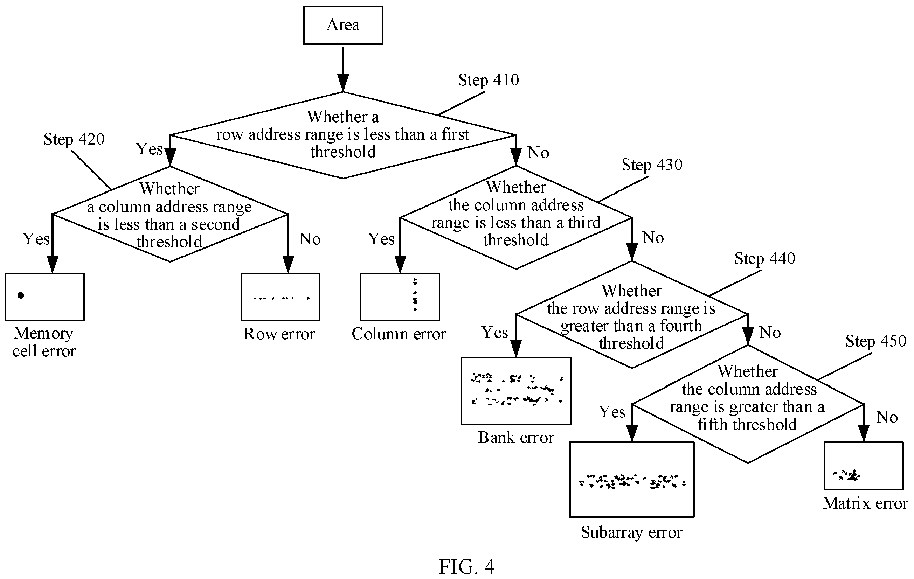

After error optimization is performed on the cluster, the computing device may determine the area based on the area size. For example, as shown in FIG. 4, the computing device performs spatial classification and demarcation based on the row address range and the column address range, to obtain a plurality of areas.

Step 410: Determine whether the row address range is less than a first threshold.

If the row address range is less than the first threshold, step 420 is performed. If the row address range is greater than the first threshold, step 430 is performed.

Step 420: Determine whether the column address range is less than a second threshold.

If the column address range is less than the second threshold, it is determined that the area is a memory cell.

If the column address range is greater than the second threshold, it is determined that the area is a single row.

Step 430: Determine whether the column address range is less than a third threshold.

If the column address range is less than the third threshold, it is determined that the area is a single column.

If the column address range is greater than the third threshold, step 440 is performed.

Step 440: Determine whether the row address range is greater than a fourth threshold.

If the row address range is greater than the fourth threshold, it is determined that the area is a bank.

If the row address range is less than the fourth threshold, step 450 is performed.

Step 450: Determine whether the column address range is greater than a fifth threshold.

If the column address range is greater than the fifth threshold, it is determined that the area is a subarray.

If the column address range is less than the fifth threshold, it is determined that the area is a matrix.

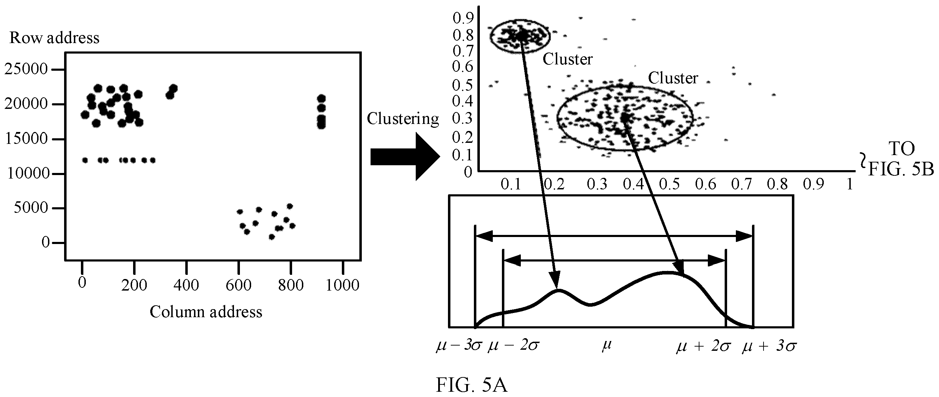

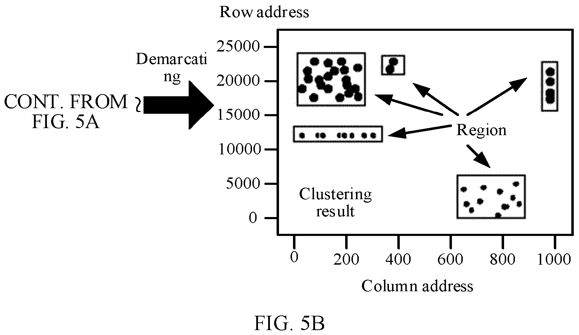

For example, FIG. 5A and FIG. 5B are a schematic diagram of a clustering result of memory error data according to an embodiment of this application. It is assumed that the space information includes a row address and a column address. The computing device performs clustering on the memory error data based on the row address and the column address that are included in the space information, to obtain a plurality of clusters. Each cluster includes memory errors at proximate locations. Spatial classification and demarcation are performed on the memory error data according to the statistical distribution 3 Sigma (3σ) law, to obtain five areas.

Further, the computing device analyzes the clustering result based on a location of the memory error in the memory and a quantity of memory errors in the memory, and decomposes the clustering result to obtain the memory error area. For example, the computing device uses a two-dimensional projection method to project the memory error data into two-dimensional coordinates based on the row address and the column address that are of the memory error and a quantity corresponding to the addresses, and performs marking in a row dimension and a column dimension based on quantities of row addresses and column addresses of the memory error. Therefore, processing on the memory error data such as clustering, decoupling, in-depth decomposing, and analyzing of a subdivided circuit structure error hidden in an area error is implemented, which helps improve an identification precision rate of a potential risk area.

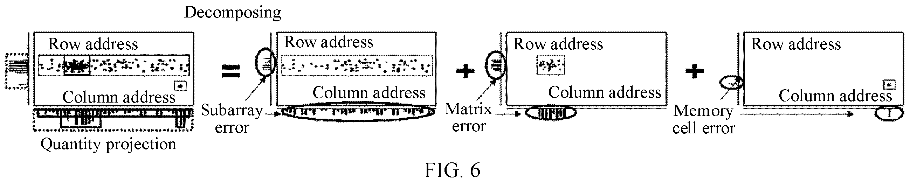

For example, as shown in FIG. 6, it is assumed that an area obtained by clustering the space information is a bank, and dense memory errors in the bank have long projections to the row address and the column address, and after decoupling based on the two-dimensional projection, are further decomposed into a memory cell error, a matrix error, and a subarray error.

The memory error area provided in this embodiment of this application includes at least one of a dual inline memory module, a rank, a memory chip, a bank group, a bank, a subarray, a matrix, a row, a column, and a memory cell.

**Step 322: The computing device determines a prediction area based on the memory error area and the memory physical structure.**

The memory physical structure indicates a connection relationship between memory cells included in a memory. The memory cells included in the memory are connected by another component in the memory to form a storage array. For example, for a row in the array, a row address decoder is connected to a plurality of main-word lines, the main-word line is connected to a plurality of sub-word line drivers, the sub-word line driver is connected to a plurality of sub-word lines, and the sub-word line is connected to a plurality of memory cells. For a column in the array, a column address decoder is connected to a plurality of column selection lines, the column selection line is connected to a plurality of sense amplifiers, the sense amplifier is connected to a plurality of bit lines, and the bit line is connected to a plurality of memory cells. In other words, the memory physical structure includes a connection relationship between the memory cells to which the main-word line, the sub-word line, the sub-word line driver, the column selection line, the bit line, the sense amplifier, the row address decoder, and the column address decoder are connected.

The computing device determines an association feature between the memory error area and the memory physical structure, and determines the prediction area based on the association feature. In other words, the computing device deduces a potential failure physical structure based on the memory error area and address space locality that is of the memory error and that is caused by limiting of the memory physical structure, and further determines the prediction area affected by the memory error.

For example, an error in one word line causes an error in a single row. If the CPU accesses some memory cells in the row, each of the some memory cells in the row reports an error, and the CPU has not accessed a memory cell at another address, the memory cell at the another address does not report an error. Because one word line is used to control a memory cell in one row, a probability of determining an error in the row is basically equivalent to a probability of determining an error in the some memory cells in the row. Based on this, a decision tree in the XGBoost algorithm correspondingly increases a weight of the error in the row.

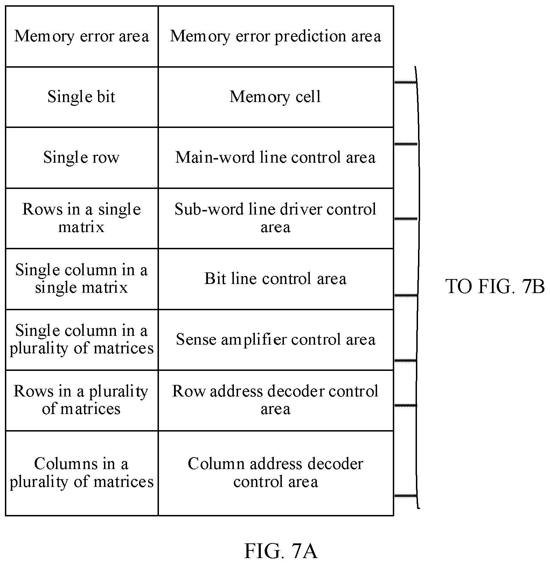

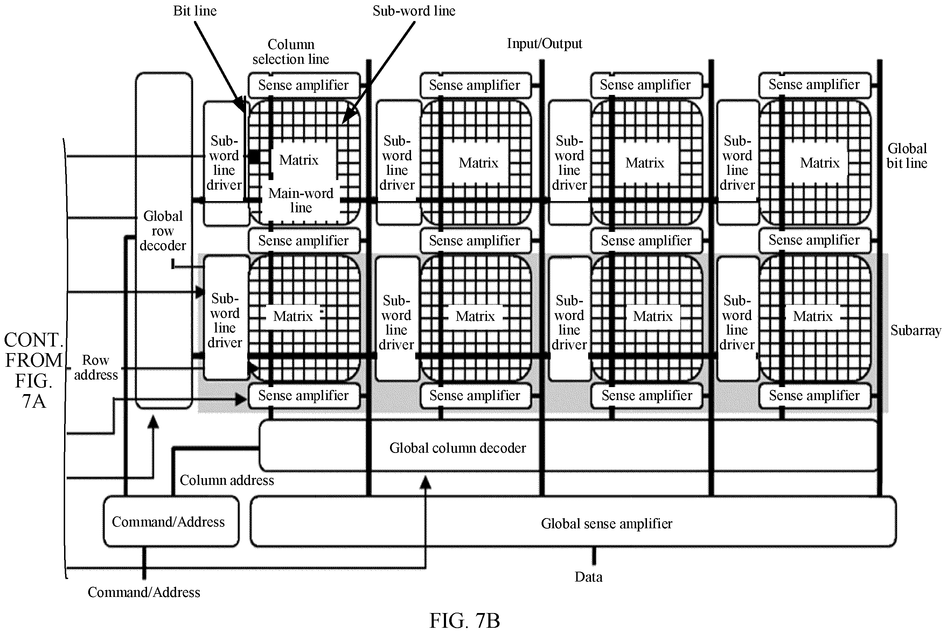

For example, as shown in FIG. 7A and FIG. 7B, an embodiment of this application provides a relationship between prediction areas corresponding to memory error areas. The prediction area includes at least one of the following:
When the memory error area is a single bit, because one memory cell is used to store 1-bit data, the prediction area is a memory cell.

When the memory error area is a single row, because one main-word line is used to control a memory cell in one row, the prediction area is a main-word line control area.

When the memory error area is a plurality of rows in a single matrix, because one sub-word line driver is configured to control a memory cell in a single-matrix, the prediction area is a sub-word line driver control area.

When the memory error area is a single column in a single matrix, because one bit line is used to control a memory cell in a single column in a single matrix, the prediction area is a bit line control area.

When the memory error area is a single column in a plurality of matrices, because one sense amplifier is configured to control a memory cell in a plurality of matrices, the prediction area is a sense amplifier control area.

When the memory error area is a plurality of rows in a plurality of matrices, because one row address decoder is configured to control a memory cell in the plurality of rows in the plurality of matrices, the prediction area is a row address decoder control area.

When the memory error area is a plurality of columns in a plurality of matrices, because one column address decoder is configured to control a memory cell in the plurality of columns in the plurality of matrices, the prediction area is a column address decoder control area.

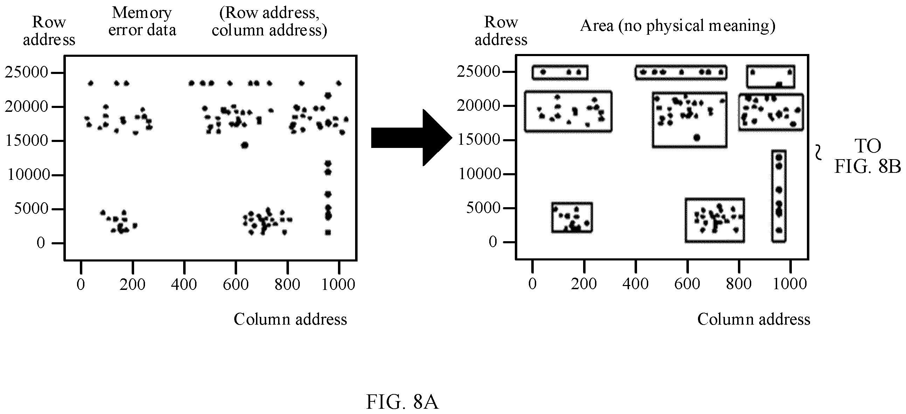

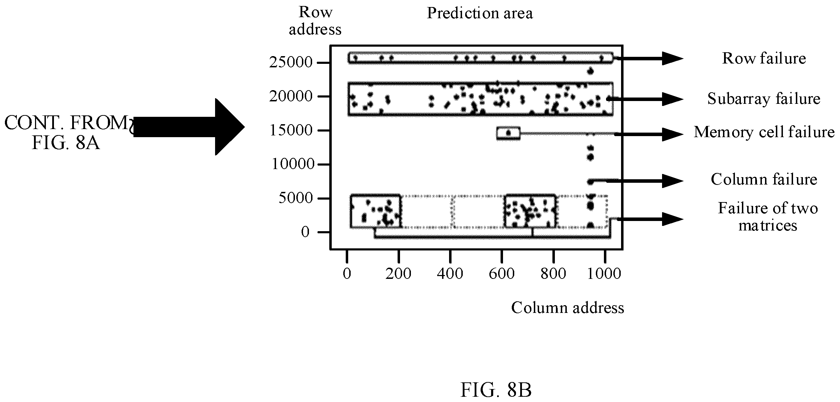

For example, as shown in FIG. 8A and FIG. 8B, after the memory error data that is distributed irregularly is derived by physical locality, a bank fault is identified as a failure of one memory cell, a failure of one row, a failure of one column, a failure of two matrices, and a failure of one subarray.

Therefore, the memory error data that is distributed irregularly is demarcated, decoupled, and deduced to locate a potential physical failure structure having a local feature.

**Step 323: The computing device determines, based on the memory error area and the time information, a time range in which the error occurs in the prediction area.**

The time information indicates a quantity or density of correctable errors that occur in the unit time, that is, indicates an occurrence time rule of the memory error. The computing device may analyze, based on historical time information of the memory error, the time range in which the error occurs in the prediction area.

The uncorrectable error (Uncorrectable Error, UCE) not only depends on an error correction capability of the CPU but also is related to a fault of the memory itself. That is, when an error correction capability of the CPU for correcting the memory fault is exceeded, the correctable error becomes the uncorrectable error. The CPU can correct an error in a single memory chip by using the memory error correction technology. If errors in a plurality of memory chips occur at the same time, the CPU cannot rectify the errors. Because a correctable error occurs in a same memory area in the plurality of memory chips, the uncorrectable error is more likely to be caused. Alternatively, a larger quantity of memory errors in unit time in each of the plurality of memory chips indicates that the uncorrectable error is more likely to be caused.

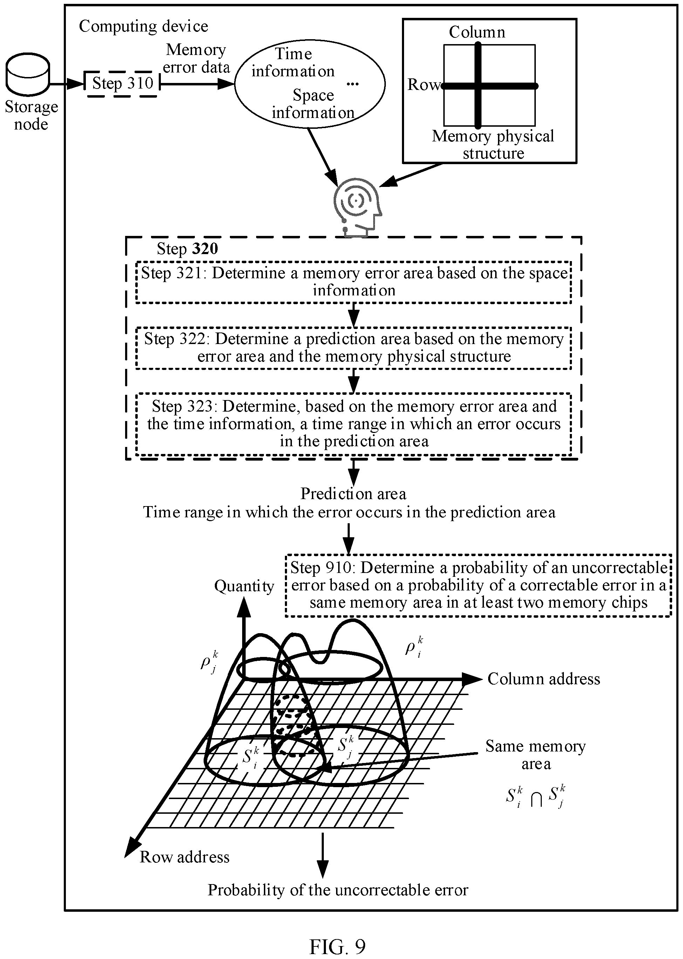

FIG. 9 is a schematic flowchart of an uncorrectable error prediction method according to an embodiment of this application.

**Step 910: A computing device determines a probability of an uncorrectable error based on a probability of a correctable error in a same memory area in at least two memory chips.**

It can be learned from the foregoing embodiment that the computing device determines, based on the time information and the space information that are included in the memory error data, a plurality of memory error areas in which the memory error occurs in the memory. The determining of the memory error area is described in the foregoing step 321.

The computing device determines an occurrence probability of a correctable error in a same memory error area in different memory chips in the memory, and determines a probability of an uncorrectable error based on the probability of the correctable error. Sizes of memory error areas in the different memory chips may be different. The different memory chips may be any two memory chips or any three memory chips in the memory, or more memory chips in which the memory error occurs. The same memory error area may be an area that has a same row address range and a same column address range in a same bank group and a same bank in the memory.

In some embodiments, the computing device determines probability density of the memory error area in the memory chip based on the probability of the memory error area in the memory chip and an area of the memory error area. The computing device determines an area of an overlapping area of memory error areas in any two memory chips in all memory chips in the memory, that is, a size of a row address range and a size of a column address range of the overlapping area of the memory error area. Then, the computing device determines probability density of the overlapping area based on probability density of the memory error areas in the two memory chips, and determines an occurrence probability of an uncorrectable error in the overlapping area based on the probability density of the overlapping area and an area of the overlapping area. The probability density of the overlapping area indicates a severity of the memory error occurring in the overlapping area.

Optionally, smooth processing or normalization processing may be performed on the probability density of the overlapping area, and inaccurate memory error data is removed, so that the probability density of the overlapping area more clearly indicates that the memory error occurs.

Therefore, in a scenario in which each of the plurality of memory chips reports an error, a surface density function of an error area of each memory chip is obtained through smoothing and normalization, and a volume integral probability of an overlapping area of historical error reporting at same addresses of the plurality of memory chips is computed with reference to an occurrence quantity of correctable errors, to evaluate an occurrence probability of the uncorrectable error. As shown in FIG. 9, a larger size of the overlapping area indicates a higher occurrence probability of the uncorrectable error and a higher risk. Based on this, the decision tree in the XGBoost algorithm correspondingly increases a weight of failures of the plurality of memory chips.

Further, the computing device determines probabilities of uncorrectable errors of any two memory chips based on occurrence probabilities of correctable errors at same locations in the any two memory chips at the same time, performs weighted summation on probabilities of all uncorrectable errors, and determines the probability of the uncorrectable error based on the weighted summation of the probabilities of all the uncorrectable errors. The computing device determines whether the probability of the uncorrectable error is greater than a threshold, and if the probability of the uncorrectable error is greater than the threshold, determines that the occurrence probability of the uncorrectable error in the memory is high.

The memory error area in that the computing device determines the probability of the uncorrectable error based on the probability of the correctable error in the same memory error area in the at least two memory chips may be replaced with a prediction area.

According to the memory error prediction method provided in this embodiment of this application, an area affected by a memory error that has occurred is predicted based on a physical structure between memory cells in the memory, so that a precision rate and a recall rate of predicting the correctable error can be effectively improved. Further, the uncorrectable error is predicted based on the correctable error and the predicted correctable error that are of the plurality of memory chips, so that a precision rate and a recall rate of predicting the uncorrectable error are also improved.

A memory error dataset of correctable errors is divided into the following three proportions of training set and test set: (1) training set:test set = 5:5; (2) training set:test set = 6:4; and (3) training set:test set = 7:3. Uncorrectable error prediction is performed separately. In a final result, a recall rate can reach 63%, and a precision rate can reach 56%. This division manner of the dataset has little impact on a model capability, and the model capability is stable.

It should be noted that the memory error prediction method provided in this embodiment of this application is also applicable to memory media such as a low power double data rate SDRAM (Low Power Double Data Rate SDRAM, LPDDR SDRAM), an HBM, a phase change memory (Phase Change Memory, PCM), a resistive random access memory (RRAM), a magnetic random access memory (Magnetoresistive Random Access Memory, MRAM), a ferroelectric memory (Ferroelectric RAM, FeRAM), an NRAM, and an SRAM, and is applicable to various memory media.

Memory quality is a major factor that leads to service instability of computing and storage products, and is one of key indicators for industry competition. The uncorrectable error is accurately predicted, so that a failure memory can be effectively replaced in a timely manner, or the failure memory can be blocked in an isolation manner. This significantly improves service reliability, improves user experience, and enhances competitiveness of a company server product. In addition, the memory quality is improved, so that product maintenance costs and the complaints and claims costs caused by customer service damage can be greatly reduced.

To implement the functions in the foregoing embodiments, the computing device includes a corresponding hardware structure and/or software module for performing each function. A person skilled in the art should be easily aware that, in combination with the units and the method steps in the examples described in embodiments disclosed in this application, this application can be implemented by using hardware or a combination of hardware and computer software. Whether a function is performed by using hardware or hardware driven by computer software depends on particular application scenarios and design constraints of the technical solutions.

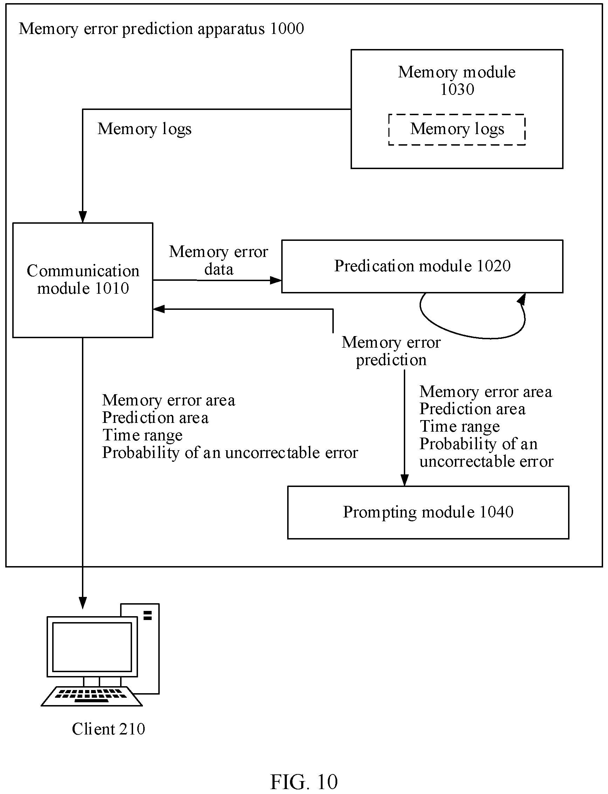

With reference to FIG. 1A and FIG. 1B to FIG. 9, the foregoing describes in detail the memory error prediction method provided in this embodiment. With reference to FIG. 10, the following describes a memory error prediction apparatus provided in this embodiment.

FIG. 10 is a schematic diagram of a possible structure of a memory error prediction apparatus according to this embodiment. The memory error prediction apparatus may be configured to implement a function of the computing device in the foregoing method embodiments, and therefore can also implement beneficial effects of the foregoing method embodiments. In this embodiment, the memory error prediction apparatus may be the computing device shown in FIG. 3 or FIG. 9, or may be a module (such as a chip) used in a server.

As shown in FIG. 10, the memory error prediction apparatus 1000 includes a communication module 1010, a prediction module 1020, and a storage module 1030. The memory error prediction apparatus 1000 is configured to implement a function of the computing node in the method embodiment shown in FIG. 3 or FIG. 9.

The communication module 1010 is configured to obtain memory error data, where the memory error data includes time information of a memory error and space information of the memory error when the memory error occurs. For example, the communication module 1010 is configured to perform step 310 in FIG. 3.

The prediction module 1020 is configured to determine, based on the memory error data and a memory physical structure, to describe a prediction area that is to be affected by the memory error in the future and a time range in which the memory error occurs in the prediction area, where the memory physical structure indicates a connection relationship between memory cells included in a memory. For example, the prediction module 1020 is configured to perform step 320 in FIG. 3.

The prediction module 1020 is further configured to: obtain an occurrence probability of a correctable error in a same memory area in at least two memory chips, where the memory area includes one of the memory error area and the prediction area; and determine a probability of an uncorrectable error based on the probability of the correctable error in the same memory area in the at least two memory chips. For example, the prediction module 1020 is configured to perform step 910 and step 920 in FIG. 9.

Optionally, the memory error prediction apparatus 1000 may further include a prompting module 1040. The prompting module 1040 is configured to prompt a user with the memory error area, the prediction area, the time range, and the probability of the uncorrectable error.

In some embodiments, the prompting module 1040 may be a display for displaying a prediction result, so that the user intuitively sees the memory error area, the prediction area, the time range, and the probability of the uncorrectable error.

In some other embodiments, the communication module 1010 is further configured to feed back the memory error area, the prediction area, the time range, and the probability of the uncorrectable error to a client for display.

The storage module 1030 is configured to store memory logs, so that the prediction module 1020 determines the prediction area affected by the memory error and the time range in which the memory error occurs in the prediction area, and predicts the probability of the uncorrectable error.

The prediction module 1020 is specifically configured to: determine the memory error area based on the space information; determine the prediction area based on the memory error area and the memory physical structure; and determine, based on the memory error area and the time information, the time range in which the error occurs in the prediction area.

The memory error prediction apparatus 1000 in this embodiment of this application may be implemented by using an application-specific integrated circuit (application-specific integrated circuit, ASIC) or a programmable logic device (programmable logic device, PLD). The PLD may be a complex program logic device (complex programmable logic device, CPLD), a field-programmable gate array (field-programmable gate array, FPGA), a generic array logic (generic array logic, GAL), or any combination thereof. When the memory error prediction method shown in FIG. 3 or FIG. 9 may alternatively be implemented by using software, and the memory error prediction apparatus 1000 and the modules of the memory error prediction apparatus 1000 may alternatively be software modules.

The memory error prediction apparatus 1000 according to this embodiment of this application may correspondingly perform a method described in embodiments of this application. In addition, the foregoing and other operations and/or functions of the units in the memory error prediction apparatus 1000 are respectively used to implement corresponding procedures of the method in FIG. 3 or FIG. 9. For brevity, details are not described herein again.

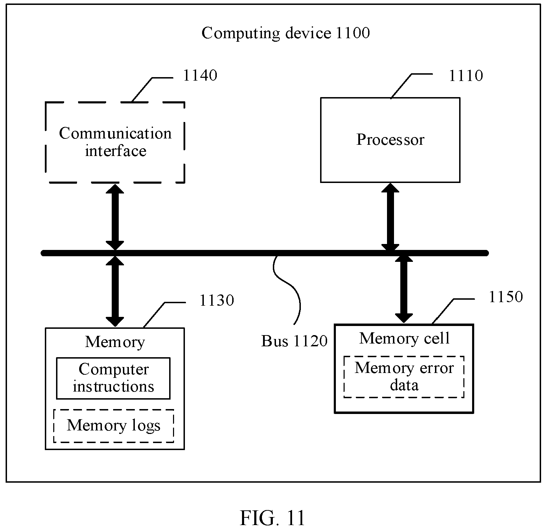

FIG. 11 is a schematic diagram of a structure of a computing device 1100 according to this embodiment. As shown in the figure, the computing device 1100 includes a processor 1110, a bus 1120, a memory 1130, a communication interface 1140, and a memory cell 1150 (which may also be referred to as a main memory (main memory) cell). The processor 1110, the memory 1130, the memory cell 1150, and the communication interface 1140 are connected through the bus 1120.

In this embodiment, the processor 1110 may be a CPU, or the processor 1110 may be another general-purpose processor, a digital signal processor (digital signal processor, DSP), an ASIC, an FPGA or another programmable logic device, a discrete gate or a transistor logic device, a discrete hardware component, or the like. The general-purpose processor may be a microprocessor, any conventional processor, or the like.

Alternatively, the processor may be a graphics processing unit (graphics processing unit, GPU), a neural network processor (neural network processing unit, NPU), a microprocessor, an ASIC, or one or more integrated circuits configured to control program execution in the solutions of this application.

The communication interface 1140 is configured to implement communication between the computing device 1100 and a peripheral device or component. In this embodiment, when the computing device 1100 is configured to implement a function of the computing device shown in FIG. 3, the communication interface 1140 is configured to obtain memory error data.

The bus 1120 may include a path for communicating information between the foregoing components (such as the processor 1110, the memory cell 1150, and the memory 1130). In addition to a data bus, the bus 1120 may further include a power bus, a control bus, a state signal bus, and the like. However, for clear description, various types of buses in the figure are marked as the bus 1120. The bus 1120 may be a peripheral component interconnect express (Peripheral Component Interconnect Express, PCIe) bus, an extended industry standard architecture (extended industry standard architecture, EISA) bus, a unified bus (unified bus, Ubus, or UB), a compute express link (compute express link, CXL) bus, a cache coherent interconnect for accelerators (cache coherent interconnect for accelerators, CCIX) bus, or the like. Buses 1120 may be classified into an address bus, a data bus, a control bus, and the like.

In an example, the computing device 1100 may include a plurality of processors. The processor may be a multi-core (multi-CPU) processor. The processor herein may be one or more devices, circuits, and/or computing units configured to process data (for example, computer program instructions). In this embodiment, when the computing device 1100 is configured to implement a function of the computing device shown in FIG. 3, the processor 1110 may determine, based on the memory error data and a memory physical structure, a prediction area affected by a memory error and a time range in which the memory error occurs in the prediction area, where the memory physical structure indicates a connection relationship between memory cells included in a memory. When the computing device 1100 is configured to implement a function of the computing device shown in FIG. 9, the processor 1110 may obtain an occurrence probability of a correctable error in a same memory area in at least two memory chips, where the memory area includes one of the memory error area and the prediction area; and determine a probability of an uncorrectable error based on the probability of the correctable error in the same memory area in the at least two memory chips.

In FIG. 11, that the computing device 1100 includes one processor 1110 and one memory 1130 is merely used as an example. Herein, the processor 1110 and the memory 1130 each indicate a type of component or device. In a specific embodiment, a quantity of components or devices of each type may be determined based on a service requirement.

The memory cell 1150 may be configured to store information such as the memory error data, which corresponds to the foregoing method embodiment. The memory cell 1150 may be a volatile memory pool or a nonvolatile memory pool, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), used as an external cache. By way of example but not limitative description, many forms of RAMs may be used, for example, a static random access memory (static RAM, SRAM), a dynamic random access memory (DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM).

The memory 1130 may correspond to the storage medium that is configured to store information such as computer instructions, memory operation instructions, and memory logs in the foregoing method embodiments, for example, a magnetic disk, such as a hard-disk drive or a solid-state drive.

The computing device 1100 may be a general-purpose device or a dedicated device. For example, the computing device 1100 may alternatively be a server or another device having a computing capability.

The computing device 1100 according to this embodiment may correspond to the memory error prediction apparatus 1000 in this embodiment, and may correspond to a corresponding entity for performing any method in FIG. 3 or FIG. 9. In addition, the foregoing and other operations and/or functions of the modules in the memory error prediction apparatus 1000 are respectively used to implement corresponding procedures of the method in FIG. 3 or FIG. 9. For brevity, details are not described herein again.

The method steps in embodiments of this application may be implemented by hardware, or may be implemented by a processor executing software instructions. The software instructions may include a corresponding software module. The software module may be stored in a random access memory (random access memory, RAM), a flash memory, a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), a register, a hard disk, a removable hard disk, a CD-ROM, or any other form of storage medium well-known in the art. For example, a storage medium is coupled to a processor, so that the processor can read information from the storage medium and write information into the storage medium. Certainly, the storage medium may be a component of the processor. The processor and the storage medium may be disposed in an ASIC. In addition, the ASIC may be located in a computing device. Certainly, the processor and the storage medium may exist in the computing device as discrete components.

All or some of the foregoing embodiments may be implemented by using software, hardware, firmware, or any combination thereof. When software is used to implement the embodiments, all or some of the embodiments may be implemented in a form of a computer program product. The computer program product includes one or more computer programs and instructions. When the computer programs or instructions are loaded and executed on a computer, the procedures or functions in embodiments of this application are completely or partially executed. The computer may be a general-purpose computer, a dedicated computer, a computer network, a network device, user equipment, or another programmable apparatus. The computer programs or instructions may be stored in a computer-readable storage medium, or may be transmitted from a computer-readable storage medium to another computer-readable storage medium. For example, the computer programs or instructions may be transmitted from a website, computer, server, or data center to another website, computer, server, or data center in a wired manner or in a wireless manner. The computer-readable storage medium may be any usable medium that can be accessed by a computer, or a data storage device, such as a server or a data center, integrating one or more usable media. The usable medium may be a magnetic medium, for example, a floppy disk, a hard disk, or a magnetic tape, may be an optical medium, for example, a digital video disc (digital video disc, DVD), or may be a semiconductor medium, for example, a solid-state drive (solid state drive, SSD). The foregoing descriptions are merely specific implementations of this application, but are not intended to limit the protection scope of this application. Any modification or replacement readily figured out by a person skilled in the art within the technical scope disclosed in this application shall fall within the protection scope of this application. Therefore, the protection scope of this application shall be subject to the protection scope of the claims.

## Claims

1. A memory error prediction method, comprising:
obtaining memory error data, wherein the memory error data comprises time information of a memory error and space information of the memory error when the memory error occurs; and
determining, based on the memory error data and a memory physical structure, to describe a prediction area that is to be affected by the memory error in the future and a time range in which the error occurs in the prediction area, wherein the memory physical structure indicates a connection relationship between memory cells comprised in a memory.

2. The method according to claim 1, wherein the time information comprises a temporal distribution feature of the memory error, and the space information comprises a location of a memory cell in which the error occurs in the memory and a spatial distribution feature of the location.

3. The method according to claim 1, wherein the memory physical structure comprises a connection relationship between memory cells to which a main-word line, a sub-word line, a sub-word line driver, a column selection line, a bit line, a sense amplifier, a row address decoder, and a column address decoder are connected.

4. The method according to any one of claims 1 to 3, wherein the determining, based on the memory error data and a memory physical structure, to describe a prediction area that is to be affected by the memory error in the future and a time range in which the error occurs in the prediction area comprises:
determining a memory error area based on the space information;
determining the prediction area based on the memory error area and the memory physical structure; and
determining, based on the memory error area and the time information, the time range in which the error occurs in the prediction area.

5. The method according to claim 4, wherein the method further comprises:
prompting a user with the memory error area, the prediction area, and the time range.

6. The method according to claim 4 or 5, wherein the space information comprises a column address and a row address of the memory cell in which the error occurs in the memory, and the determining a memory error area based on the space information comprises:
classifying the memory cell in which the error occurs based on a column address range of the memory cell in the memory and a row address range of the memory cell in the memory, to obtain the memory error area.

7. The method according to any one of claims 4 to 6, wherein the memory error area comprises at least one of the following: a dual inline memory module, a rank, a memory chip, a bank group, a bank, a subarray, a matrix, a row, a column, and a memory cell.

8. The method according to claim 7, wherein the prediction area comprises at least one of the following:
when the memory error area is a single bit, the prediction area is a memory cell;
when the memory error area is a single row, the prediction area is a main-word line control area;
when the memory error area is a plurality of rows in a single matrix, the prediction area is a sub-word line driver control area;
when the memory error area is a single column in a single matrix, the prediction area is a bit line control area;
when the memory error area is a single column in a plurality of matrices, the prediction area is a sense amplifier control area;
when the memory error area is a plurality of rows in a plurality of matrices, the prediction area is a row address decoder control area; or
when the memory error area is a plurality of columns in a plurality of matrices, the prediction area is a column address decoder control area.

9. The method according to any one of claims 1 to 8, wherein the method further comprises:
determining a probability of an uncorrectable error based on a probability of a correctable error in a same memory area in at least two memory chips, wherein the memory area comprises one of the memory error area and the prediction area.

10. The method according to any one of claims 1 to 9, wherein the obtaining memory error data comprises:
obtaining the memory error data from memory logs.

11. A memory error prediction apparatus, comprising:
a communication module, configured to obtain memory error data, wherein the memory error data comprises time information of a memory error and space information of the memory error when the memory error occurs; and
a prediction module, configured to determine, based on the memory error data and a memory physical structure, to describe a prediction area that is to be affected by the memory error in the future and a time range in which the error occurs in the prediction area, wherein the memory physical structure indicates a connection relationship between memory cells comprised in a memory.

12. The apparatus according to claim 11, wherein the time information comprises a temporal distribution feature of the memory error, and the space information comprises a location of a memory cell in which the error occurs in the memory and a spatial distribution feature of the location.

13. The apparatus according to claim 11, wherein the memory physical structure comprises a connection relationship between memory cells to which a main-word line, a sub-word line, a sub-word line driver, a column selection line, a bit line, a sense amplifier, a row address decoder, and a column address decoder are connected.

14. The apparatus according to any one of claims 11 to 13, wherein when determining, based on the memory error data and the memory physical structure, to describe the prediction area that is to be affected by the memory error in the future and the time range in which the error occurs in the prediction area, the prediction module is specifically configured to:
determine a memory error area based on the space information;
determine the prediction area based on the memory error area and the memory physical structure; and
determine, based on the memory error area and the time information, the time range in which the error occurs in the prediction area.

15. The apparatus according to claim 14, wherein the apparatus further comprises a prompting module; and
the prompting module is configured to prompt a user with the memory error area, the prediction area, and the time range.

16. The apparatus according to claim 14 or 15, wherein the space information comprises a column address and a row address of the memory cell in which the error occurs in the memory, and when determining the memory error area based on the space information, the prediction module is specifically configured to:
classify the memory cell in which the error occurs based on a column address range of the memory cell in the memory and a row address range of the memory cell in the memory, to obtain the memory error area.

17. The apparatus according to any one of claims 14 to 16, wherein the memory error area comprises at least one of the following: a dual inline memory module, a rank, a memory chip, a bank group, a bank, a subarray, a matrix, a row, a column, and a memory cell.

18. The apparatus according to claim 17, wherein the prediction area comprises at least one of the following:
when the memory error area is a single bit, the prediction area is a memory cell;
when the memory error area is a single row, the prediction area is a main-word line control area;
when the memory error area is a plurality of rows in a single matrix, the prediction area is a sub-word line driver control area;
when the memory error area is a single column in a single matrix, the prediction area is a bit line control area;
when the memory error area is a single column in a plurality of matrices, the prediction area is a sense amplifier control area;
when the memory error area is a plurality of rows in a plurality of matrices, the prediction area is a row address decoder control area; or
when the memory error area is a plurality of columns in a plurality of matrices, the prediction area is a column address decoder control area.

19. The apparatus according to any one of claims 11 to 18, wherein the prediction module is further configured to:
determine a probability of an uncorrectable error based on a probability of a correctable error in a same memory area in at least two memory chips, wherein the memory area comprises one of the memory error area and the prediction area.

20. The apparatus according to any one of claims 11 to 19, wherein when obtaining the memory error data, the communication module is specifically configured to:
obtain the memory error data from memory logs.

21. A computing device, wherein the computing device comprises a memory and at least one processor, the memory is configured to store a set of computer instructions, and when executing the set of computer instructions, the processor performs the operation steps of the method according to any one of claims 1 to 10.
